# EUROPEAN PATENT APPLICATION

(11) **EP 2 334 144 A1**
(43) Date of publication of application: **15.06.2011**
(21) Application number: 10153502.9
(22) Date of filing: 12.02.2010
(51) Int. Cl.: H05B 33/08, G01R 31/26

(54) **Testing of LEDs**

(30) Priority: 07.09.2009 EP 09169653
(71) Applicant: NXP B.V., 5656 AG Eindhoven (NL)
(72) Inventor: Bancken, Pascal, Redhill, Surrey RH1 1DL (GB); Nguyen Hoang, Viet, Redhill, Surrey RH1 1DL (GB); Surdeanu, Radu, Redhill, Surrey RH1 1DL (GB)
(74) Representative: Burton, Nick

(57) **Abstract**

A method of determining the ageing characteristics of an LED comprises applying a current stress pulse to the LED. The LED is monitored to determine when the thermal heating induced by the current stress pulse has been dissipated to a desired level. The operational characteristics of the LED are then measured before applying the next stressing pulse.

This method accelerates the effect of aging in a reproducible way and therefore is able to greatly reduce the time needed for a reliability test.

## Description

This invention relates to lighting devices using light emitting diodes (LEDs), and particularly to the testing of such devices.

Lighting using solid-state devices such as LEDs is gaining momentum. The use of LEDs for lighting has several advantages over the use of conventional light sources, including a better light output/dimension ratio and improved power efficiency.

It is reported that the average life time of a LED is approximately 50,000 hours instead of 2000 hours for an incandescent light bulb. As a result, LEDs are the preferred light source in difficult-to-replace lighting fixtures (street lights, traffic signal lights) and/or in fixtures that require higher reliability (automotive lights) for safety reasons.

Despite the long LED life time, like many other light sources, the light output from a LED decays over time as a result of an aging process, ultimately leading to LED failure. It is generally accepted that an LED with light output level at 70% of its pristine value needs to be replaced. Depending on the operating conditions of the LED, the time at which it needs to be replaced varies greatly.

Currently, light sources including LEDs are typically replaced according to a fixed schedule. In this manner, some of the lights are still operational and are discarded. It can also happen that a light source is burnt out before its next scheduled maintenance. Thus, maintenance according to a fixed schedule is not the best solution for lighting fixtures especially for those at difficult to reach places and if safety (or cost) is of concern.

Therefore, knowing the ageing behaviour of LED's would be desirable to enable improved design of a system using LEDs. However, because the projected lifetime of LED is in the range of 50000 hrs, it is not practical to observe LED aging behaviour in operating conditions. There is a need for an accelerated aging method for LEDs that can shorten the test time but without introducing extra damage to the device.

According to the invention, there is provided a method of determining the ageing characteristics of an LED, comprising:
(i) applying a current stress pulse to the LED;
(ii) after the current stress pulse, monitoring the LED to determine when the thermal heating induced by the current stress pulse has been dissipated to a desired level;
(iii) after the thermal heating has been dissipated to the desired level, measuring operational characteristics of the LED; and
(iv) repeating steps (i) to (iii) until the determination of the ageing characteristics is complete.

This method accelerates the effect of aging in a reproducible way and therefore is able to greatly reduce the time needed for a reliability test. Furthermore, this method allows an increase in speed for implementing feedback on changes in the manufacturing and assembly of LED packages and their impact on the aging effects of the LED.

The information obtained relating to the ageing characteristics can be used to design a driver circuit which takes into account the LED performance over time and adjusts the drive conditions accordingly. The driver is then able to work with LEDs of all ages, by knowing the optical output performance at different ages and being able to predict the age of an LED being driven.

The prediction of the age of an LED can be made by measuring LED characteristics and matching these to the characteristics obtained during the testing method of the invention.

The determination of the ageing characteristics can be deemed to be complete when one or more operational characteristics have reached a threshold level, indicative of the end of the life of the LED.

The method preferably further comprises a calibration process of:
(i) bringing the LED under measurement to a stable temperature; and
(ii) measuring the pristine performance of the LED including optical and electrical performance characteristics.

The optical and electrical performance characteristics can comprise one or more of:
the peak wavelength,
the spectrum width; and
the current-voltage characteristic.

The current stress pulse preferably has a current value greater than the maximum rated current of the LED. In this way, it provides accelerated ageing of the LED. The current stress pulse is designed to accelerate the ageing process. In general, there are three parameters to accelerate the ageing; the junction temperature, the stress current and the stress duration. The junction temperature is the heat sink temperature raised by an amount which is a function of the stress current and duration. Thus, the junction temperature depends on the stress current pulse, but it can also be controlled to an extent by controlling the heat sink temperature. To accelerate the ageing, conditions can be chosen such as a low heat sink temperature and high stress current, or a low current and high heat sink temperature.

The current stress pulse preferably has a current value greater than the maximum rated current of the LED. In one example, the current stress pulse has a current value in the range 0.5A to 10A, for example 2A to 5A, but the value will depend on the nature of the LED being tested.

Each current stress pulse can have a duration of 1 s to 30s.

The current value and duration will be selected to provide the desired ageing without providing catastrophic damage to the LED. The pulse may be sufficient to raise the temperature of the diode to over 30°C above the ambient temperature, or even over 50°C above the ambient temperature.

Monitoring the LED (to determine temperature) can comprise monitoring the diode forward voltage over time. The thermal heating induced by the current stress pulse can then be determined to have dissipated to the desired level when time the derivative of the forward voltage falls below a predetermined value.

More generally, the thermal heating induced by the current stress pulse is determined to have dissipated to the desired level when the derivative of a temperature-dependent parameter falls below a predetermined value.

Measuring operational characteristics can comprise one or more of:
determining the peak wavelength,
determining the spectrum width (e.g. full width half max value FWHM); and
performing a current-voltage scan.

Other known analyses can also be carried out.

The invention also provides a testing circuit for determining the ageing characteristics of an LED, comprising:
a current source circuit for applying a current stress pulse to the LED;
a temperature monitoring circuit for monitoring the LED to determine when the thermal heating induced by the current stress pulse has been dissipated to a desired level; and
analysis circuitry for measuring operational characteristics of the LED after the thermal heating has been dissipated to the desired level.

Examples of the invention will now be described with reference to the accompanying drawings, in which:
Figure 1 shows a current stress pulse which can be used in the method of the invention;
Figure 2 shows the LED response to the stress pulse of Figure 1;
Figure 3 shows how the LED characteristics are monitored when the test sequence is non-ideal;
Figure 4 shows how the LED characteristics are monitored using a test sequence of the invention; and
Figure 5 shows the optical arrangement of a testing system which implements the method of the invention.
Figure 6 shows the test method of the invention as a sequence of steps;
Figure 7 shows the output intensity varies with age;
Figure 8 shows how the FWHM and peak wavelength vary with age;
Figure 9 shows how the forward voltage varies with age;
Figure 10 shows how the junction temperature after a stress pulse varies with age; and
Figure 11 shows the electrical arrangement of a testing system which implements the method of the invention.

The invention provides a test method for determining the ageing characteristics of an LED and a test circuit for performing the method.

The invention makes use of deliberate stressing pulses to induce ageing of the LED, with junction temperature measurement/estimation used to control the application of the stressing pulses. Different approaches for performing junction temperature measurement/estimation of an LED are known, and these will be outlined before describing the invention in further detail.

During operation, the LED temperature increases and this influences the amount of light output of the LED as well as the dominant wavelength of the output light. Thus, it has previously been recognised that a knowledge of the temperature at the junction of a LED is useful for controlling the LED to have maximum performance.

Temperature measurement can be used to provide a feedback value for use in controlling the LED driver conditions. Typically, the LED junction temperature is measured using an external temperature sensor located close to the LED. This method has one major disadvantage that the measured temperature is not the real temperature at the LED junction (which is usually higher). To compensate for this error, sophisticated thermal diffusion models can be used to predict (or extrapolate) the LED junction temperature based on the measured temperature from the sensor. The accuracy of the junction temperature prediction is heavily dependent on the quality of the model, and the accuracy of the parameters that are used in the model, such as thermal resistance and thermal capacitance of the packaging materials surrounding the LED etc.

Another known method to measure LED junction temperature is to monitor the forward voltage of the LED while driving a constant current through it. This method uses the LED itself as a temperature sensor, and therefore saves cost and also should enable improved accuracy. However, the current through the LED can introduce a so-called self-heating effect which in turn makes the temperature reading less accurate. A solution to avoid the self-heating effect of the LED is to use a very small current for LED junction temperature measurement. Using a small current to measure the forward-voltage of the LED means it can only be done when the LED is turned off. This approach is therefore suitable for a testing process (such as used in this invention) but is less suitable for a real time monitoring process.

Another method involves detecting the forward voltage of the LED while it is illuminating at operational current and to map this to the ambient temperature of the LED. The value of temperature is then translated to an appropriate current needed to drive the LED by means of a table look up method.

The applicant has proposed (but not yet published) another method of estimating the junction temperature of a light emitting diode, in which a forward bias current is driven through the diode, the current comprising a square wave which toggles between high and low current values. The high current value is an LED operation current, and the low current is a non-zero measurement current. The forward bias voltage drop is sampled, in order to determine the forward bias voltage drop at the measurement current. The temperature is then derived from the determined forward bias voltage drop. This method enables a low measurement current to be used but at the same time enables the measurement to be taken in real time - with the low measurement current being applied during the off periods of a PWM control cycle.

According to this invention, stressing pulses are applied to the LED, and the LED status is measured by sending electrical signals to the LED after the stress pulse. Temperature monitoring or estimation is used to deduce when the thermal effect of the stress pulse is diminished so that only the aging of the LED will affect the next stress pulse. This provides an optimised test process which can rapidly simulate ageing of the LED. In particular, the testing time can be minimised by monitoring the junction temperature after the stress pulse so that the next stress pulse can be applied as soon as the junction temperature is stable (at heat sink temperature).

Any of the temperature measurement approaches outlined above can be employed. The testing process is not carried out in normal use of the device, so that there is no need to enable the temperature measurement to be possible during use of the LED (which is an aim in some of the known temperature measurement methods outlined above). Also, accuracy of the result is not critical - a safety margin (i.e. additional time between stress pulses) can be built in to the process to make sure there is sufficient cooling between stress pulses, to take account of expected inaccuracies in the temperature estimation. Thus, it can be seen that many different temperature measurement approaches are possible.

The simplest approach is simply to provide a constant measurement current after the stress pulse and to monitor the forward voltage.

The invention provides a method of determining the ageing characteristics of an LED in which a current stress pulse is applied to the LED. The temperature of the LED is then monitored to determine when the thermal heating induced by the current stress pulse has been dissipated to a desired level. The electrical characteristics of the LED are then measured, before the next stress pulse is applied.

The stress pulse provides an elevated stress condition which gives rise to an elevated junction temperature of the LED. The heat sink temperature can be kept constant (but elevated). The spread in lifetime experienced with this constant heat sink temperature is thus reflected in the differences in junction temperature. The stress current applied is larger than the maximum rated current of the LED, and the duration of the pulse is selected to cause ageing of the LED.

By way of example, for a high power LED, the heat sink temperature may be elevated to over 50°C (30°C above a typical ambient temperature of 20°C), or even over 70°C, for example to 85°C. The stress current may be in the range 0.5A to 10A (for example 2.5A) and the duration of the stress pulse may be 1 s to 30s (for example 10s).

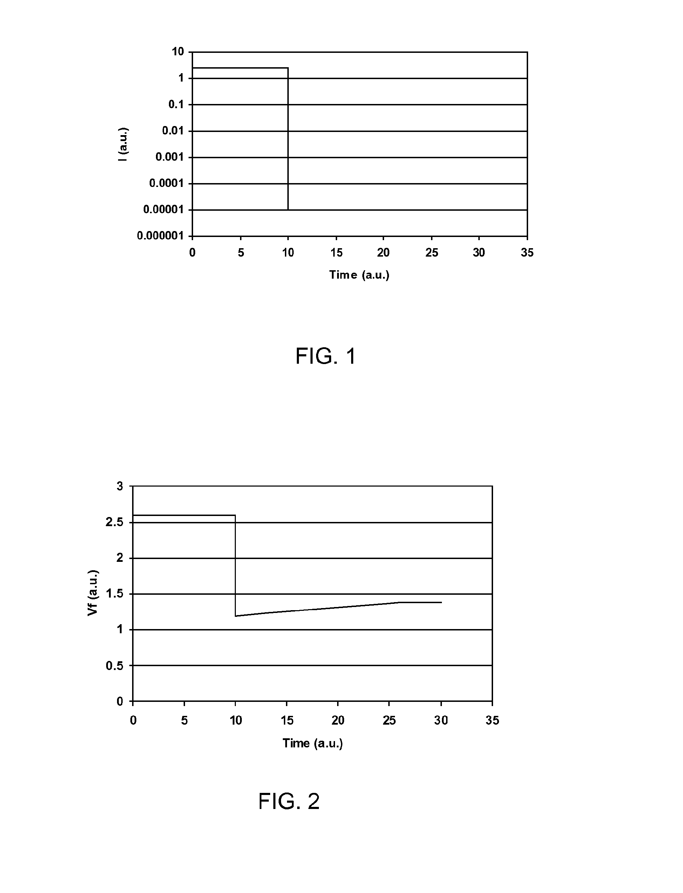

Figure 1 shows an example of stress pulse (using arbitrary units), of a high current for a first duration (10 units) followed by a low measurement current (over 100,000 times smaller).

When the temperature measurement involves monitoring the forward voltage, as in the most simple example, the stress pulse is followed by this monitoring of the forward voltage at a low measurement current, until the derivative of the forward voltage over time is below a threshold. This ensures the junction temperature has recovered to the temperature of the heat sink.

Figure 2 shows how the forward voltage varies during and after application of the stressing pulse. After the stressing pulse, the forward voltage drops to a first level. This level is influenced both by the prevailing temperature and the electrical characteristics of the LED. In Figure 2, the forward voltage has stabilised at the point in time shown as 25 time units. The electrical characteristics of the LED are then dictated solely by the state of ageing of the device, and not the temperature. Thus, the electrical measurements to determine the electrical characteristics are taken after time 25. As shown, this corresponds to the time at which the gradient of the forward voltage has become zero (or passed a threshold close to zero).

Thus, after the junction temperature is approximately equal to the heat sink temperature, characterization measurements of the LED can be preformed because the characterization will not be influenced by the increased temperature induced by the stress pulse but merely by the aging of the LED. The characterization can include optical as well as electrical measurements to determine the properties of the LED over age, such as peak wavelength, spectrum width such as FWHM value and IV-scan (i.e. a scan of the voltage versus current characteristics).

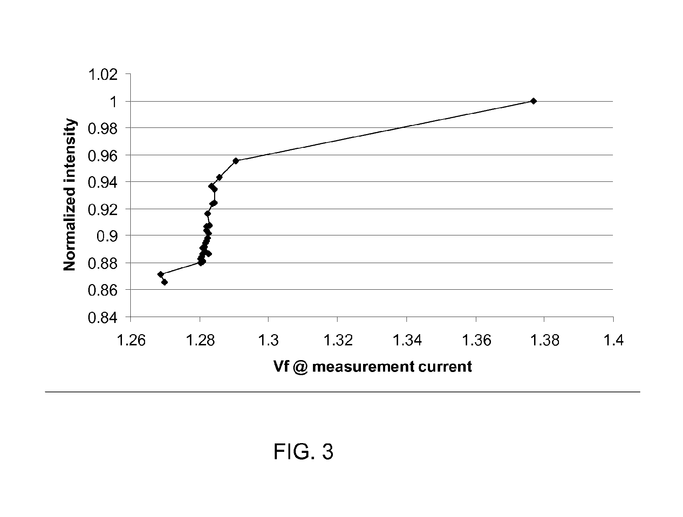

Figure 3 shows the normalized light output intensity as function of the forward voltage at the measurement current, for a non optimized stress measurement. The output intensity and voltage measurement is plotted after each stress pulse.

Figure 3 shows the effect when the waiting time between stress pulses is not sufficiently long. The first 25 data points (starting at the normalised light intensity of 1) represent one stress pulse followed by the electrical characterization step, witch consists of optical spectrum grabbing and an IV-scan. The time between stress pulses is quite large and may be sufficient for cooling to take place. However, the last 2 data points represent 5 stress pulses at a time (with minimal waiting between the stress pulses) followed by the characterization step. Thus, these show a situation in which thermal cooling back to the ambient temperature is prevented. Figure 3 shows a general trend in the first 25 data points, but not a smooth function, and also shows discontinuities in the last 2 data points. The discontinuous nature of the last 2 data points is a clear indication of the higher junction temperature influencing the measurements.

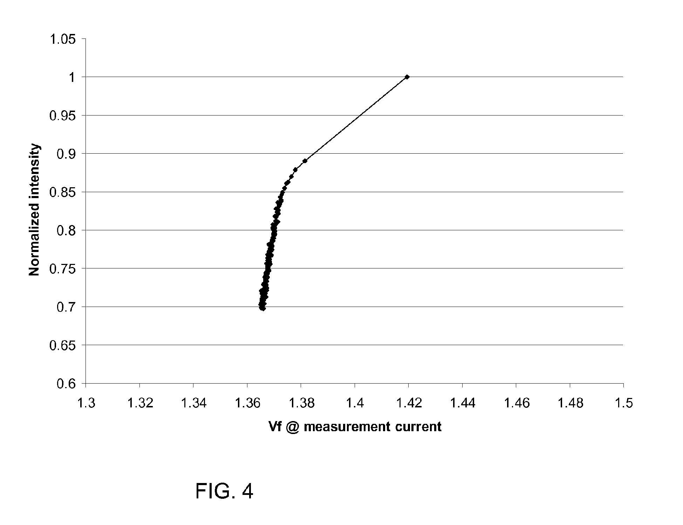

Figure 4 shows the normalized Intensity as function of forward voltage at the measurement current for an optimized stress measurement in accordance with the invention, in which adequate cooling is ensured after each stress pulse.

Figure 4 shows that when the junction temperature is used to ensure proper cool down of the sample, then the LED aging follows a continuous smooth curve.

As a result, the ageing characteristics of the LED can be modelled much more accurately following the testing process of the invention.

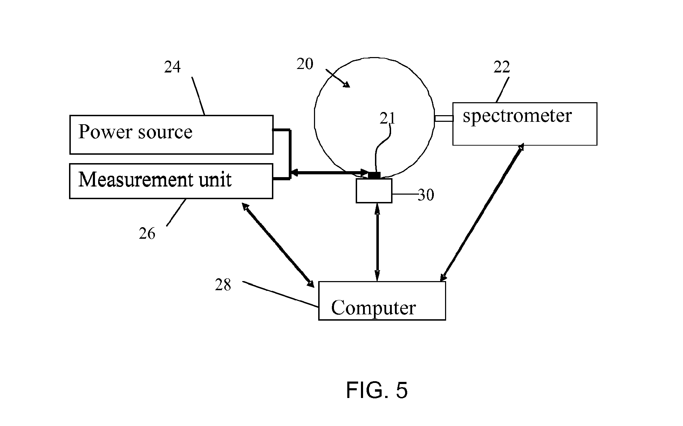

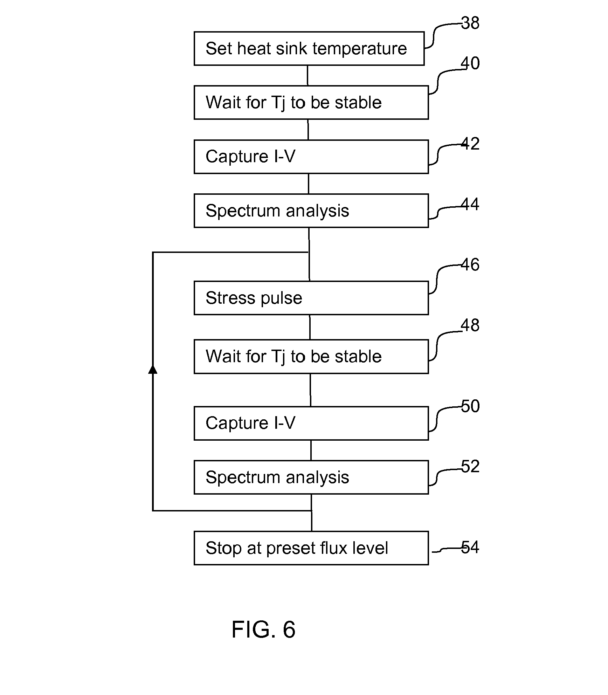

The optical part of the test setup is shown in Figure 5, and Figure 6 shows the test sequence.

The arrangement of Figure 5 comprises an integrating sphere 20 for directing all light output from the LED 21 to an output at which a spectrometer 22 is provided. The LED is controlled by a power source 24 and a measurement unit 26 implements the forward voltage measurements (or other electrical measurements). The system is under the control of a computer 28. A controllable thermal chuck is shown as 30.

The process of Figure 6 comprises:
Step 38: setting a heat sink temperature;
Step 40: waiting for a stable LED junction temperature;
Step 42: capturing the I-V curve for the pristine diode;
Step 44: measuring the output light spectrum at the given operating current for the pristine diode;
Step 46: applying the stressing pulse explained above;
Step 48: monitoring the cooling of the device based on the Vf measurements and waiting for a stable diode junction temperature;
Step 50: capturing the I-V curve for the now aged diode; and
Step 52: measuring the output light spectrum at the given operating current for the now aged diode.
Steps 46 to 52 are repeated to provide data for different degrees of ageing.

The process is ended (step 54) when the output flux of the diode has dropped to a level indicative of the end of the life of the diode.

Experiments have been conducted to analyse the effectiveness of the ageing test.

A set of blue LED diodes in their pristine state were found to have an average peak light output wavelength of 480.9nm with a standard deviation of 0.8nm. The light output intensity was found to be 1.93 x 10⁶ (arbitrary count units) with a standard deviation of 7.3%. The FWHM (i.e. the wavelength spread) was found to be 32nm with standard deviation of 1.04nm. The forward voltage was on average 1.993V with a standard deviation of 23.7mV for a current of 0.001 mA and 4.255V with a standard deviation of 31.6mV for a current of 1A.

The set of diodes was subjected to the ageing test. To reach a predetermined reduction in light intensity corresponding to the end of the LED life (typically a value of the output flux dropping to 70% of the pristine value) an average of around 1500 10s stressing pulses at 2.5A were needed, or an average of 350 10s stressing pulses at 2.75A. Thus, assuming a cooling time of 30 seconds on average, in the former case the testing process takes around 16 hours, and in the latter case around 4 hours.

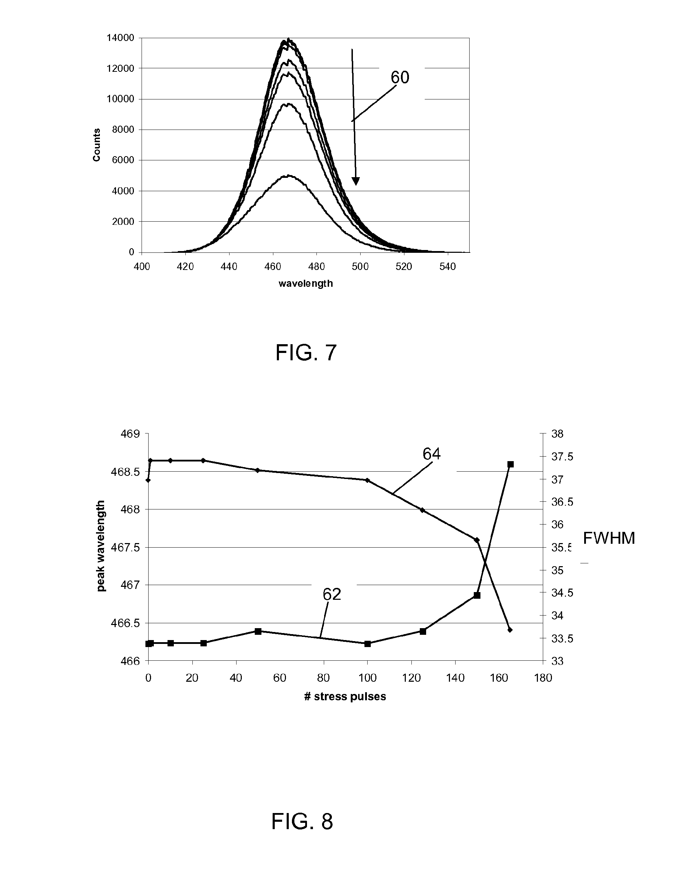

Analysis of the results shows that the intensity reduces with ageing, but the wavelength shifts very little. This is shown in Figure 7. Arrow 60 shows increases age (i.e. number of ageing pulses).

Figure 8 shows how the peak wavelength varies (plot 62) and the FWHM (plot 64).

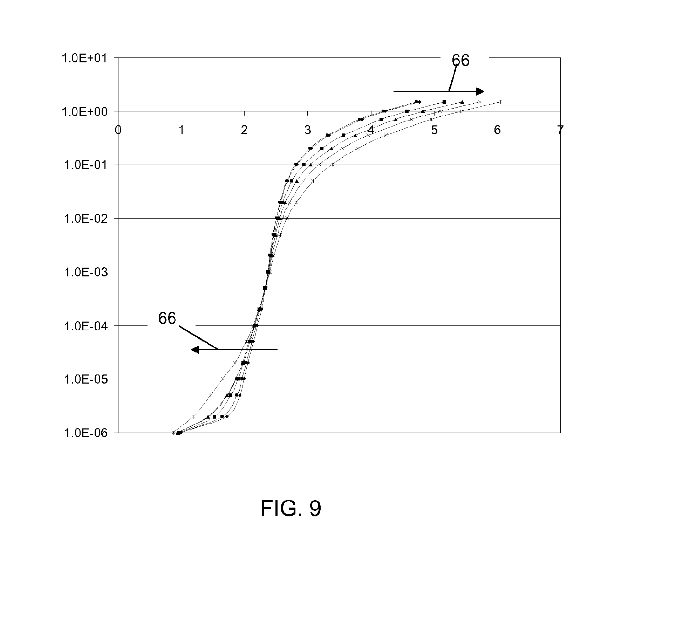

The forward voltage at the operating current (1A in this example) increases with age, but the forward voltage at low current (0.001 mA in this example) decreases with age. This is shown in Figure 9. Arrow 66 represents increasing age (i.e. number of ageing pulses).

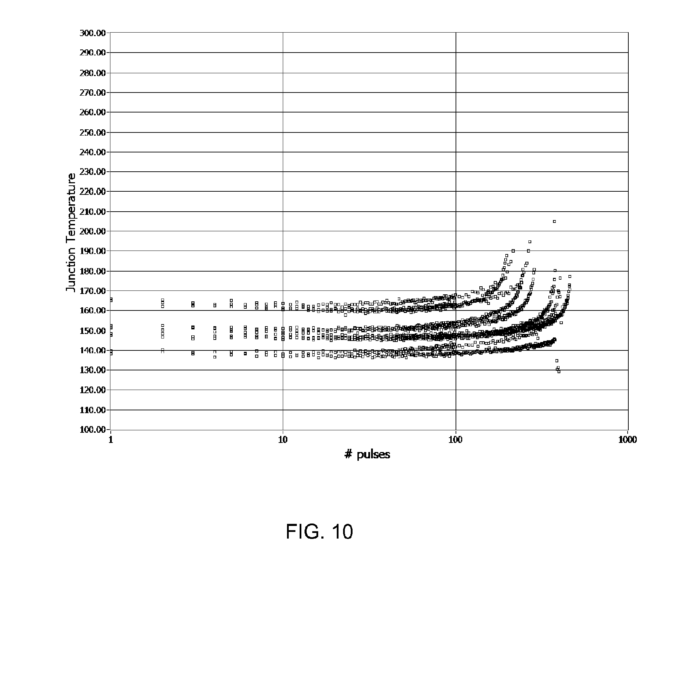

There is also a clear correlation between the junction temperature immediately after the stressing pulse and the age (as represented by the number of stressing pulses). This relationship is shown in Figure 10 for the different diodes of the set, and relates to 10s ageing pulses of 2.75A.

The temperature increase shown in Figure 10 is found to be a cause (rather than an effect) of the ageing of the diode. By improving the thermal coupling between the diode and the heat chuck, for example using heat sink compounds, the lifetime is significantly improved.

The testing of the invention enables an ageing profile to be determined. As can be seen from the analysis above, a forward voltage measurement, a temperature estimation after a stressing pulse, or an intensity measurement can be linked to a particular point along the progression of the these parameters with age. The testing process gives the evolution of these parameters between the pristine condition and the end of the useful life of the diode, but without actual time values for the age of the diode (the x-axis is the number of ageing pulses). However, by determining where along the aging curve a diode lies (regardless of the actual time that this corresponds to), it is possible to adapt the drive conditions for the diode accordingly.

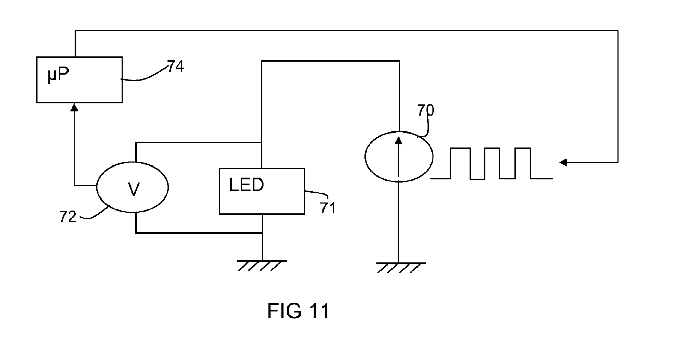

The design of the electrical circuitry used in the test setup of Figure 5 will be routine to those skilled in the art. An example is shown schematically in Figure 11, and which implements the power source 24, measurement unit 26 and computer 28 of Figure 5..

A current source circuit 70 is used for driving a forward bias current through the diode 71, and this current comprises the waveform described above.

The forward bias voltage drop is measured by a voltage measurement circuit 72, and the results are provided to a processor 74. The processor 74 performs the analysis of the rate of change of forward voltage. In addition, the current source circuit and voltage measurement circuit can be used for determining the IV characteristics. Additional electrical and/or optical circuitry is used for carrying out any other required measurements of the electrical or optical characteristics of the LED after each stressing pulse and cooling period, as shown in Figure 5, but further sensor or measurement devices may be used.

The method of the invention can be applied in any LED system used in general lighting, back- or side-lit LCD TVs or automotive applications.

The measurements taken to characterise the performance of the LED at different ageing instants have not been described in detail, as these will be routine to those skilled in the art. The invention relates to the control of the timing of the stressing (ageing) pulses and the timing of the measurements of the LED characteristics, in particular, the duration of the time period between pulses, using feedback of temperature dependent parameters. The temperature dependent parameter may be a voltage measurement as in the example above, but instead direct measurement of temperature may be employed. Indeed, any known approach for estimating the temperature (or monitoring a parameter which is known to depend on temperature) may be used.

The measurement current will be significantly lower than the stressing current, for example 1mA compared to 1A. Thus, a factor of 1000 will be typical, although the factor may be between 100 and 1000000, or more likely between 1000 and 100000.

The invention can be applied to high power or low power LEDS. The stressing pulse will be designed to provide the desired incremental ageing effect without causing abrupt damage to the LED.

The design of the ageing pulses will be a balance between the current density and the duration of the test.

Various other modifications will be apparent to those skilled in the art.

## Claims

1. A method of determining the ageing characteristics of an LED, comprising:
(i) (46) applying a current stress pulse to the LED;
(ii) (48) after the current stress pulse, monitoring the LED to determine when the thermal heating induced by the current stress pulse has been dissipated to a desired level;
(iii) (50,52) after the thermal heating has been dissipated to the desired level, measuring operational characteristics of the LED; and
(iv) repeating steps (i) to (iii) until the determination is complete.

2. A method as claimed in claim 1, further comprising a calibration process of:
(i) (38,40) bringing the LED under measurement to a stable temperature; and
(ii) (42,44) measuring the pristine performance of the LED including optical and electrical performance characteristics.

3. A method as claimed in claim 2, wherein the optical and electrical performance characteristics comprise one or more of:
the peak wavelength,
the spectrum width; and
the current-voltage characteristic.

4. A method as claimed in any preceding claim, wherein the current stress pulse has a current value greater than the maximum rated current of the LED.

5. A method as claimed in any preceding claim, wherein the current stress pulse has a current value in the range 0.5A to 10A.

6. A method as claimed in any preceding claim, wherein each current stress pulse has a duration of 1 s to 30s.

7. A method as claimed in any preceding claim, wherein the current stress pulse has a current value and a duration sufficient to raise the temperature of the diode to over 30°C above the ambient temperature.

8. A method as claimed in claim 7, wherein the current stress pulse has a current value and a duration sufficient to raise the temperature of the diode to over 50°C above the ambient temperature.

9. A method as claimed in any preceding claim, wherein monitoring the LED comprises monitoring the diode forward voltage over time.

10. A method as claimed in claim 9, wherein the thermal heating induced by the current stress pulse is determined to have dissipated to the desired level when the derivative of the forward voltage falls below a predetermined value.

11. A method as claimed in one of claims 1 to 9, wherein the thermal heating induced by the current stress pulse is determined to have dissipated to the desired level when the derivative of a temperature-dependent parameter falls below a predetermined value.

12. A method as claimed in any preceding claim, wherein measuring operational characteristics comprises one or more of:
(52) determining the peak wavelength,
(52) determining the spectrum width; and
(50) determining the current-voltage characteristic.

13. A testing circuit for determining the ageing characteristics of an LED, comprising:
a current source circuit (70) for applying a current stress pulse to the LED (71);
a temperature monitoring circuit (72,74) for monitoring the LED to determine when the thermal heating induced by the current stress pulse has been dissipated to a desired level; and
analysis circuitry (74) for measuring operational characteristics of the LED after the thermal heating has been dissipated to the desired level.

14. A circuit as claimed in claim 13, wherein analysis circuitry (74) adapted to determine the peak wavelength, and/or the spectrum width and/or the current-voltage characteristic.
